Europäisches Patentamt

European Patent Office

Office européen des brevets

(11) Publication number: 0 349 001
A2

# EUROPEAN PATENT APPLICATION

(21) Application number: 89111961.2

(22) Date of filing: 30.06.89

(51) Int. Cl.4: H01L 23/31 , H01L 23/28

(30) Priority: 30.06.88 JP 163560/88

(43) Date of publication of application:
03.01.90 Bulletin 90/01

(84) Designated Contracting States:
DE FR GB

(71) Applicant: KABUSHIKI KAISHA TOSHIBA
72, Horikawa-cho Saiwai-ku
Kawasaki-shi Kanagawa-ken 210(JP)

(72) Inventor: Nakazawa, Tsutomu C-410 Toshiba
Hiyoshi Ryo 4-14-1
Hiyoshi-Hon-Cho Kohoku-Ku
Yokohama-Shi Kanagawa-Ken(JP)
Inventor: Ichikawa, Keiji
1454-4, Imajuki-Higashi-Cho Asahi-Ku
Yokohama-Shi Kanagawa-Ken(JP)
Inventor: Ohno, Jun-ichi
1-24-24, Nagata-Higashi Minami-Ku
Yokohama-Shi Kanagawa-Ken(JP)

(74) Representative: Lehn, Werner, Dipl.-Ing. et al
Hoffmann, Eitle & Partner Patentanwälte
Arabellastrasse 4
D-8000 München 81(DE)

(54) Semiconductor device having a stress relief film protected against cracking.

(57) A semiconductor device wherein a stress relief film (12) of polyimide or like substance is formed on the complete surface of a semiconductor chip (10) in order to eliminate inconveniences arising from a difference between the thermal expansion rates of the insulating film and encapsulating plastic of the device. The stress relief film has apertures (13, 13a) formed therein for individually exposing the underlying bonding pads (11) on the chip.

In order to avoid the concentration of stresses at the acute or right-angled corners, if any, of each aperture during the fabrication of the stress relief film by the photoetching process, and the consequent cracking of the film, each aperture (13, 13a) is made substantially circular in shape, for example, exactly circular, or rectangular with beveled corners.

FIG. 3

## BACKGROUND OF THE INVENTION

This invention relates generally to semiconductor devices, and more specifically to those having a relatively large size chip with a stress relief film formed thereon. Still more specifically, the invention deals with means for preventing the cracking of the stress relief film during the fabrication of the semiconductor device.

The specialists in the art of microcircuit fabrication technology are familiar with some inconveniences that manifest themselves in connection with semiconductor devices having plastic-encapsulated chips, particularly when the chips are as large in size as, say, 10 millimeter square or more. Such inconveniences are:

1. High shearing stresses at the periphery of the chip, resulting in the lack of adhesion of the contiguous parts, in pad corrosion and, consequently, in a decrease in resistance to moisture.

2. Cracking of ther insulating layer, as of PSG, on the chip, and the sliding of the aluminum wiring, due to differences in thermal expansion rates of the encapsulating plastic, the frame material, and the semiconductor chip under thermal stresses.

3. Expansion or cracking of the semiconductor device through partial detachment from one another of the chip and the encapsulation, or of the bonding pads and the frame, at the time of the high temperature mounting of the chip, with the consequent deterioration of resistance to moisture.

There is one obvious reason for all such defects of larger size semiconductor devices. That reason is that the difference between the thermal expansion rates of the insulating film and the encapsulating plastic becomes more and more pronounced with an increase in size of semiconductor packages.

The usual conventional remedy for such defects has been the provision of what may be termed a stress relief film on semiconductor chips for mitigating thermal stresses. The stress relief film is fabricated from polyimide or like material that is intermediate in thermal expansion rate between the insulating film and the encapsulating plastic.

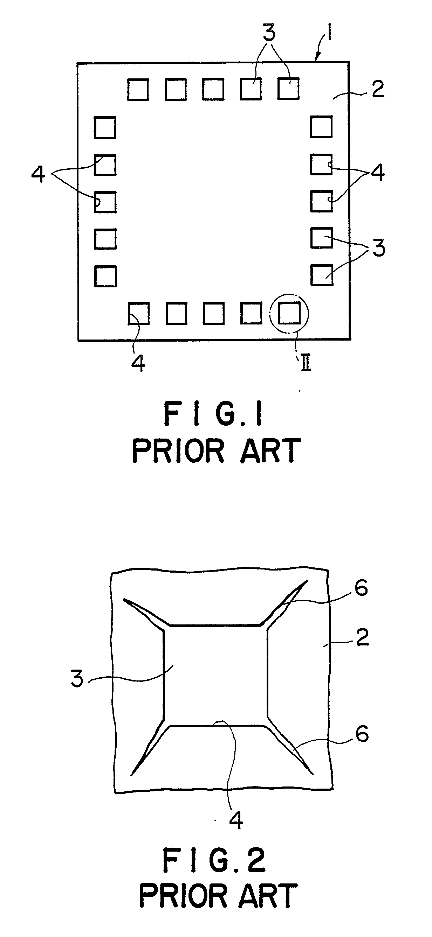

Unlike alpha particle shields on memories or the like, the stress relief film covers not only the semiconductor elements but as much area of the chip as practical, including the corners of the chip which are subject to particularly high shearing stresses. Actually, it has been formed on all but the bonding pads of the chip (as in FIG. 1 of the drawings attached hereto). The apertures in the stress relief film exposing the bonding pads have so far been of approximately the same shape as the bonding pads, that is, the apertures have been rectangular in shape, with four right angles.

The usual method of forming the stress relief film is such that, first of all, a desired substance such as polyimide is dropped onto a silicon wafer on which semiconductor elements have been fabricated. Then the wafer is revolved at a sufficient speed to centrifugally spread the substance into a film of unvarying thickness. Then, following the solidification of the film, those parts of it which overlie the bonding pads are etched away to create the rectangular apertures.

The above outlined method unavoidably gives stresses to the film as the latter contracts during solidification. Such stresses tend to concentrate at the corners of each rectangular aperture during the subsequent photoetching process. Further, upon completion of the photoetching process, the stresses on the wafer are distributed among the individual chips. The possible result has been the development of cracks in the stress relief film, with the cracks running from the corners of each aperture in a direction away from the opposite corners (FIG. 2).

The present applicant has ascertained by the following tests that the cracking of the stress relief film results in the loss or diminution of its intended functions. The tests conducted were the accelerated moisture-proofness test and the temperature cycle test. The samples tested were 144-pin flat packages of plastic-encapsulated semiconductor chips, each 10 millimeter square in size, with the conventional stress relief films formed conventionally thereon. As a result of 120 hours of the accelerated moistureproofness test, approximately one out of every 15 samples was found defective. One thousand cycles of the temperature cycle test proved that approximately one out of every 30 samples was defective.

## SUMMARY OF THE INVENTION

The present invention seeks to reduce the cracking of the stress relief films on semiconductor chips, particularly on larger size ones, to a minimum and hence to enable the films to perform their intended functions to a maximum possible degree.

Briefly, the invention may be summarized as a semiconductor device comprising a semiconductor chip having a plurality of bonding pads formed on its surface in a prescribed arrangement. A stress relief film is formed on the surface of the semiconductor chip in overlying relation to the bonding pads. Apertures are formed in the stress relief film for exposing the respective bonding pads therethrough. Each aperture is more or less circular in shape, for example, exactly circular, substantially elliptic, or rectangular with each corner rounded or formed into a pair of obtuse angles.

With the stress relief film apertured in accordance with the teachings of the invention, as set forth above, the concentration of stresses at the film edges bounding the apertures is practically avoided, regardless of the size of the chip or which the film is formed. As the film is thus producible with little or no cracks, it will perform its intended functions to the full.

The above and other features and advantages of the invention and the manner of realizing them will become more apparent, and the invention itself will best be understood, from a study of the following description and appended claims, with reference had to the attached drawings showing some preferable embodiments of the invention.

## BRIEF DESCRIPTION OF THE DRAWINGS

FIG. 1 is a plan view of a semiconductor chip having a stress relief film apertured in accordance with the prior art;

FIG. 2 is an enlarged, fragmentary plan view showing that part of the prior art apertured stress relief film which is indicated by the broken line circle designated II in FIG. 1;

FIG. 3 is a plan view of the semiconductor chip having the stress relief film apertured in accordance with the novel concepts of the invention;

FIG. 4 is an enlarged, fragmentary plan view of that part of the apertured stress relief film of the invention which is indicated by the broken line circle designated IV in FIG. 3; and

FIG. 5 is a view similar to FIG. 3 but showing another preferable embodiment of the invention.

## DETAILED DESCRIPTION

The prior art semiconductor chip 1 shown in FIG. 1 has a stress relief film 2 of polyimide or like material formed on its complete surface. The stress relief film 2 has a series of apertures 4 disposed along its periphery to expose the respective bonding pads 3 of the chip. It will be noted that each aperture 4 is rectangular in shape, with the four right angles, to conform to the shape of each bonding pad 3.

As illustrated on an enlarged scale in FIG. 2, each rectangular aperture 4 is easy to develop cracks 6 in the stress relief film 2. The cracks 6 tend to originate at the right angular corners of each aperture 4, each running in a direction away from the opposite corner of the aperture. It has already been set forth how and why these cracks develop at the corners of the apertures 4. The present invention solves the problem of how to minimize the development of such cracks in the stress relief film, as set forth in detail hereafter.

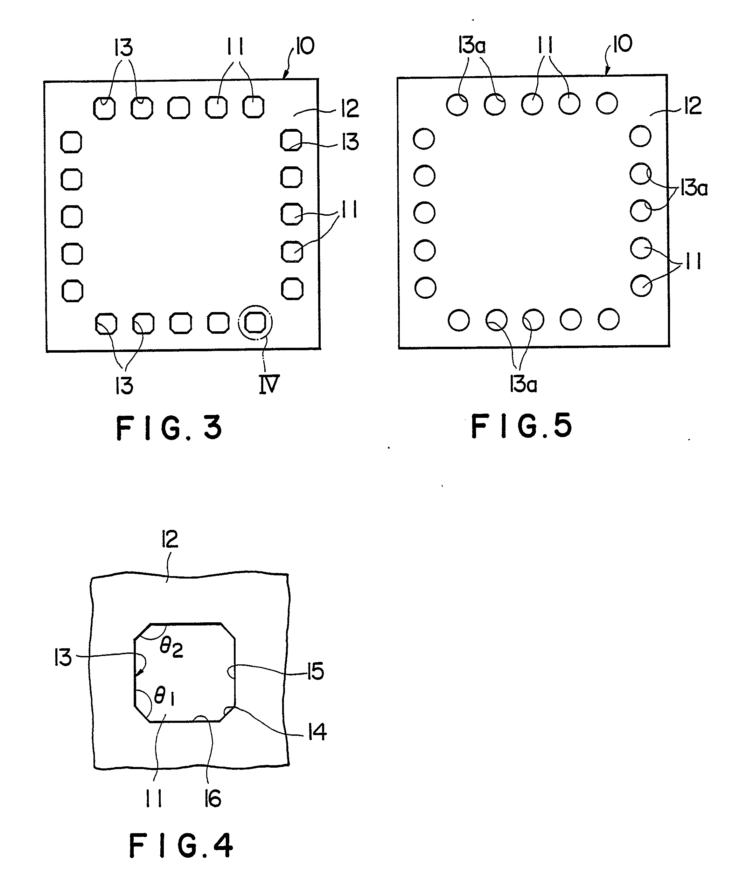

FIG. 3 shows a preferred form of the semiconductor device according to the invention, comprising a semiconductor chip 10 of generally rectangular shape. Formed on one surface of the semiconductor chip 10 are any required number of bonding pads 11 of suitable placement, and a stress relief film 12 of polyimide or like material covering the complete surface of the chip. The stress relief film 12 is apertured at 13 to individually expose the underlying bonding pads 11.

As illustrated on an enlarged scale in FIG. 4, each aperture 13 in the stress relief film 12 is substantially rectangular or square in shape in this particular embodiment. Unlike the prior art, however, the four corners of each aperture 13 are all beveled at 14 to eliminate the right angles and hence to avoid stress concentrations at the corners. The angles $\theta_1$ and $\theta_2$ thus formed between each bevel 14 and the two neighboring sides 15 and 16 of each aperture 13 are both 135 degrees in this particular embodiment.

The stress relief film 12 with the apertures 13 in the form of beveled rectangles can be fabricated largely by the conventional photoetching patterning method, as has been described in connection with the prior art stress relief film 2, FIGS. 1 and 2, having the unbeveled rectangular apertures 4. Only the photomask may be shaped in conformity with the beveled rectangular apertures 13 of the invention.

In another preferred embodiment of the invention illustrated in FIG. 5, the stress relief film 12 has apertures 13a of circular shape, in lieu of the beveled rectangular apertures 13 of the preceding embodiment, for exposing the bonding pads 11 on the semiconductor chip 10. The circular apertures 13a are, of course, free from any sharp angles or corners and so virtually eliminates the possibility of the cracking of the film 12 for the same reasons as has been set forth in conjunction with the first described embodiment.

The semiconductor chips 10 of FIGS. 3 and 5 may be plastic encapsulated to provide semiconductor devices.

The noted accelerated moistureproofness test and temperature cycle test were conducted each on 30 samples of 144-pin flat packages of 10 millimeter square semiconductor chips fabricated in accordance with the invention. No defective one was found as a result of 120 hours of the accelerated moistureproofness test and of 1000 cycles of the temperature cycle test.

Despite the foregoing detailed disclosure, it is not desired that the invention be limited by the exact details of the illustrated embodiments. A variety of modifications or alterations will readily occur to one skilled in the art within the broad teaching hereof. For example, in the embodiment of FIGS. 3 and 4, each bevel 14 of each aperture 13 may be concaved for still more smoothly joining the neighboring sides 15 and 16.

## Claims

1. A semiconductor device wherein a stress relief film (12) is formed on a semiconductor chip (10) and has apertures (13, 13a) formed therein in order to individually expose bonding pads (11) on the chip, characterized in that each aperture (13, 13a) is made substantially circular in shape in order to minimize the possibility of the cracking of the stress relief film (12) during the fabrication thereof.

2. A semiconductor device as claimed in claim 1, wherein each aperture (13) in the stress relief film (12) is rectangular in shape, characterized in that the corners of each rectangular aperture (13) is beveled (14).

3. A semiconductor device as claimed in claim 1, characterized in that each aperture (13a) in the stress relief film (12) is circular in shape.

F I G.I
PRIOR ART

F I G.2
PRIOR ART

F I G. 3

F I G. 5

F I G. 4